Europäisches Patentamt

European Patent Office

Office européen des brevets

(11) Publication number: **0 072 181**
A2

# EUROPEAN PATENT APPLICATION

(21) Application number: **82304089.4**

(51) Int. Cl.³: **H 03 K 7/08**

(22) Date of filing: **03.08.82**

(30) Priority: **05.08.81 GB 8123988**
**14.08.81 GB 8124950**

(43) Date of publication of application: **16.02.83**
**Bulletin 83/7**

(84) Designated Contracting States: **AT BE CH DE FR IT LI**
**LU NL SE**

(71) Applicant: **THE MARCONI COMPANY LIMITED, The**
**Grove Warren Lane, Stanmore Middlesex HA7 4LY (GB)**

(72) Inventor: **Fitz, Philip John, 5, Hollywood Close, Great**
**Baddow, Chelmsford, Essex (GB)**
Inventor: **Molyneaux-Berry, Robert Bewes, 12, Hopping**
**Jacks Lane, Danbury Essex (GB)**

(74) Representative: **Tolfree, Roger Keith, Marconi House**
**New Street, Chelmsford, CM1 1PL (GB)**

(54) **A pulse width modulator.**

(57) In a pulse width modulation amplifier comprising a pulse width encoder 2 followed by a filter 5 a problem arises when the average pulse duration changes substantially within the filter delay time. The risk of this is reduced by the present invention by a circuit 7 which has the effect of setting an upper limit to the rate of change or «slew rate» of the input signal.

## A PULSE WIDTH MODULATOR

This invention relates to a pulse width modulator.

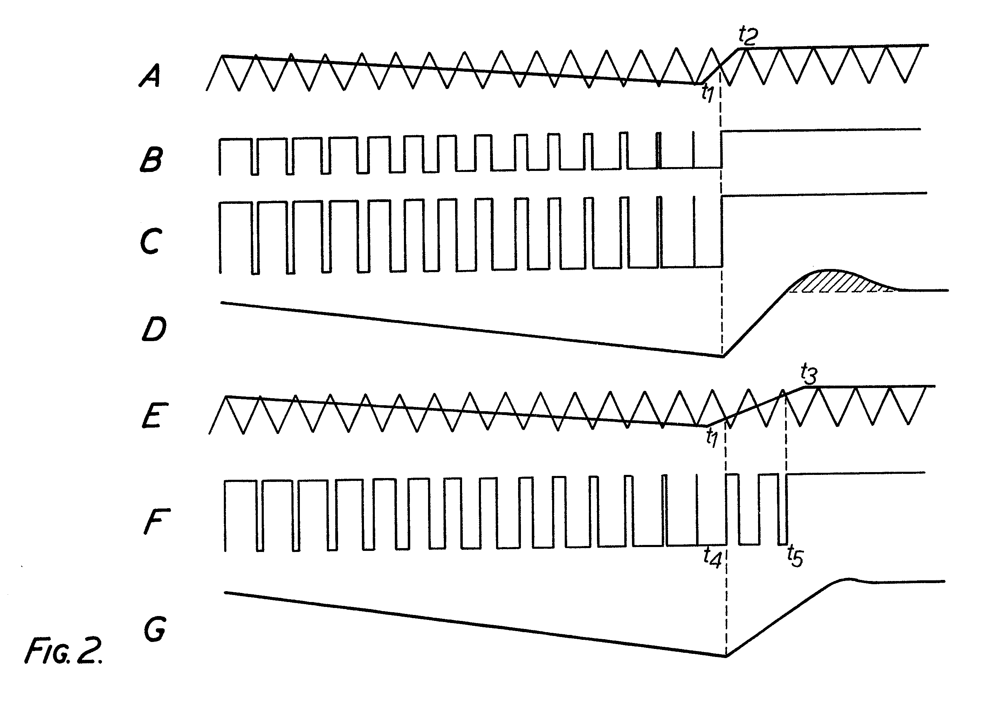

A known pulse width modulator will now be described with reference to the accompanying drawings but ignoring the circuit indicated generally at 7 which incorporates features of the present invention.    An amplitude modulated signal, which may be an audio signal, and which is shown by the heavy line on Fig. 2A, enters the system at the terminal 1 and is compared in a pulse width encoder 2 with a high frequency saw-tooth waveform (also shown in Fig. 2A) thereby providing at 3 a series of pulses whose average duration is a measure of the amplitude of the input signal at 1. ' The amplitude of these pulses (shown in Fig.2B) is amplified (Fig.2C) by an amplifier 4.  A resonant low pass filter 5 is used to produce an output 6 (Fig. 2D) which is a measure of the average pulse duration and is therefore an amplified version of the input, delayed slightly by the filter 5.

Input frequencies higher than the saw-tooth repetition frequency cannot be transmitted by this system and, in practice, only input frequencies significantly less (5 to 10 times less) than the saw-tooth repetition frequency are transmitted without unacceptable distortion.

If the input to the filter 5 is such that the average pulse duration changes substantially within the filter delay time, as indicated between $t_1$ and $t_2$ on Fig. 2A, an overshoot will result (i.e., the amplitude at the filter output will temporarily exceed a value which corresponds to the average pulse duration) as shown by the shaded area on Fig. 2C.   This condition is also characterised by excess currents and voltages circulating between component parts of the filter.

The worst input to the filter from the point of view of causing overshoot is a step change from a very low, approximately zero, average pulse width to a very high, approximately

100%, pulse width (or vice versa) where the change occurs in a time much less than the filter delay and where the states before and after the change persist for times much greater than the filter delay.   An example of an input to the filter likely to cause a high degree of excess internal circulation is a continuously applied full amplitude excitation at or close to the maximum pass band frequency of the filter i.e., where the period of the oscillating excitation is closely related to the filter delay and to the resonance of internal subsections of the filter.   These examples of undesirable inputs are merely worst cases of input conditions which occur normally but to a lesser extent in some types of audio material and to a substantial extent under certain common overload conditions.

Where overshoot at the output is unacceptable, e.g., in a pulse width modulation radio frequency transmitter where overmodulation of the transmitted RF signal is not permissable or where it is desired to minimise circulating currents within a high power filter, the input to the filter must be suitably constrained.   It is thus desirable to remove as completely as possible all constituent frequency components likely to cause undesirable effects in the filter or its output whilst minimising distortion or error in the output.

A known method of avoiding the undesirable effects referred to above is to insert a low pass filter before the encoder so that frequency components approaching the encoder saw-tooth repetition frequency are severely attentuated and by choosing the cut-off frequency of the high power main filter (e.g., filter 5) to lie between the cut off frequency of the low pass filter referred to and the saw-tooth pulse repetition frequency.   A disadvantage of this known system is that in practice it requires that the saw-tooth repetition frequency be very much higher (at least 10 times higher) than the highest input frequency which can be satisfactorily transmitted to the output.  A further disadvantage is that very heavy overloads (excessive input amplitudes) are not necessarily attenuated sufficiently entirely to avoid the above problems.

The present invention aims to overcome the above difficulties by preceding the encoder, not with a low pass filter, but with a circuit designed to prevent rates of change of amplitude (slew rates) higher than a particular level, which level is constant for different frequencies and different input amplitudes. Accordingly, the invention provides apparatus comprising a pulse width modulator which produces output pulses whose duration varies with variations in an input signal characterised by processing means arranged to receive an input signal before it is fed to the pulse width modulator so as to impose an upper limit on the rate of change of the input signal when applied to the pulse width modulator.

The preferable upper limit is that which is present at the point of inflection of a sine wave input of normal maximum amplitude and of the highest frequency which it is desired to transmit at that full amplitude.  The saw-tooth repetition frequency may be chosen so that an input of full amplitude at the maximum set slew rate must cut the saw-tooth in at least three, but preferably 5 to 7 points.  The filter 5 must be designed so that its delay time is a little less than the time taken for the line of chosen maximum slew rate completely to traverse the saw-tooth.  In this manner it has been found possible to reduce the saw-tooth repetition frequency to less than about 10 times the maximum input frequency to be transmitted at the full amplitude and with low distortion. This reduces switching losses.

The idea of using a slew rate limiter to prevent overshoot in a low pass filter is applicable to systems other than P.W.M. systems.    Thus, according to another aspect of the invention there is provided apparatus comprising a low pass filter arranged to receive signals via means for imposing an upper limit on the rate of change of the signals.

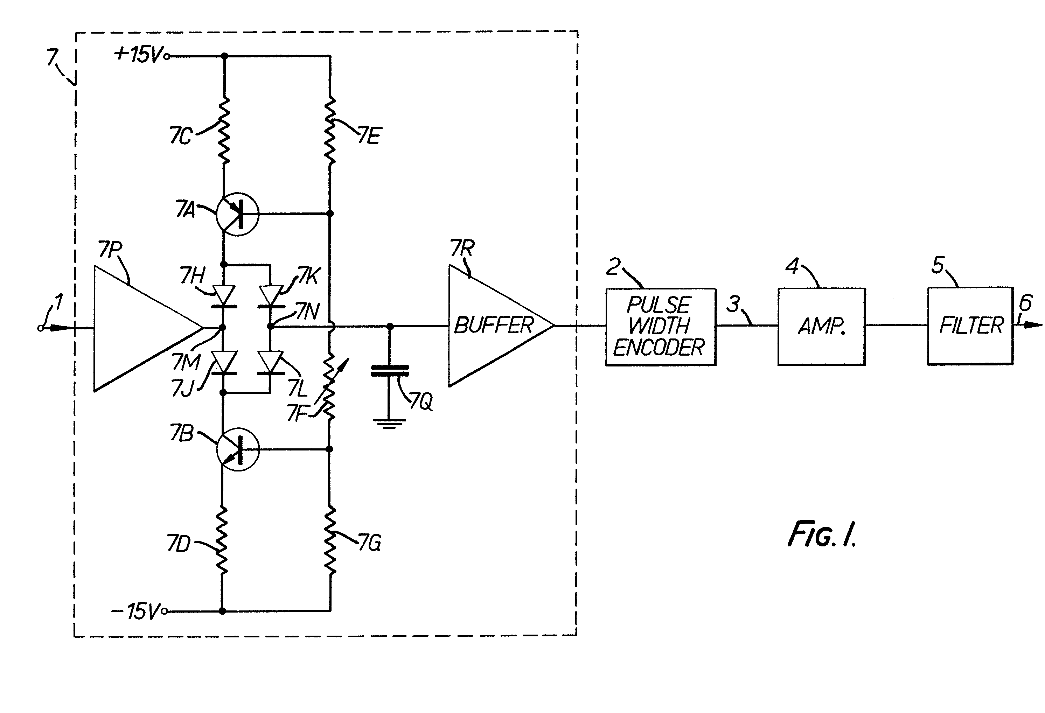

One way in which the invention may be performed will now be described by way of example with reference to the accompanying drawing and in particular with reference to the circuitry indicated at 7 on Figure 1.

The rate of change, i.e., slew rate, of the input signal applied to the pulse width encoder 2 is prevented by the circuit 7, which will be referred to as the "slew rate limiter" from exceeding a certain critical value.    However, the slew rate limiter 7 leaves the input signal substantially undistorted when its slew rate does not exceed this critical value.

The slew rate limiter 7 comprises constant current source formed by two transistors 7A, 7B, two resistors 7C, 7D, a potential divider formed from resistors 7E, 7F and 7G and sources of voltage of plus and minus 15 volts as indicated.    The transistor bases are biassed by the potential divider 7E, 7F, 7G so that the transistors pass a constant current which is equally divided between diodes 7H and 7J on the one hand and diodes 7K and 7L on the other hand.

Because, with the diodes positively biassed, there is only a small resistance between points 7M and 7N, the voltage of the point 7N tends to follow the voltage of the input signal applied via buffer 7P to the point 7M. However, point 7M is connected to one terminal of a capacitor 7Q and so the rate of change or "slew rate" of the voltage at 7N cannot exceed the rate at which the capacitor 7Q is charged or discharged by all the available currents from the constant current source.    The voltage at point 7N is applied via a buffer 7R to the pulse width modulation encoder 2.

The slew rate limiter 7 thus has the effect of preventing the slew rate of the input signal from exceeding the desired critical value thereby avoiding the problems previously referred to.

The slew rate limit can be adjusted by varying the setting of the variable resistor 7F.

Fig. 2E shows how the slew rate limiter changes the audio signal of Fig. 2A.   Because of the slew rate limitation imposed on this signal, the rise time, previously $t_1$ to $t_2$, but effectively zero (Figs.2B, 2C) is increased to $t_1$ to $t_3$ but effectively $t_4$ to $t_5$ (Fig. 2F) less than or equal to the delay time of the filter. Therefore the filter output as shown in Fig. 2G does not overshoot.

It will be noted from Fig.2E that the saw-tooth repetition frequency must be chosen so that the signal rising from its minimum to its maximum value between $t_1$ and $t_3$ crosses the saw-tooth a sufficient number of times to enable satisfactory pulse coding of the signal during this period.   Three times is the minimum but five or seven is preferable.   More than seven is less preferable since it achieves little or no advantage at the expense of a higher pulse repetition frequency.

CLAIMS:-

1.    Apparatus comprising a pulse width modulator (2) which produces output pulses whose duration varies with variations in an input signal characterised by processing means (7) arranged to receive an input signal before it is fed to the pulse width modulator (2) so as to impose an upper limit on the rate of change of the said input signal when applied to the pulse width modulator.

2.    Apparatus according to claim 1 characterised in that the processing means is constructed so that the processed input signal changes at a rate equal to the said upper limit when the unprocessed input signal changes at a rate exceeding said upper limit.

3.    Apparatus according to claim 1 or 2 characterised in that the processing means (7) is constructed so that it does not substantially distort the input signal when the rate of change of the latter is below the upper limit.

4.    Apparatus according to any preceding claim characterised in that the processing means (7) comprises:

a diode arrangement (7H,7J,7K,7L) having two arms connected in parallel, each arm containing two diodes in series;

means (7P) for applying the unprocessed input signal to a first point (7M) between the diodes (7H,7J) of one arm;

a capacitor (7Q) connected to a second point (7N) between the diodes (7K,7L) of the other arm;

a constant current source (7A,7B,7C,7D,7E,7F,7G) connected to pass a constant current through the diode arrangement, and means (7R) for applying a processed input signal from the capacitor (7Q) to the pulse width modulator (2).

5.    Apparatus according to claim 1 characterised in that the pulse width modulator (2) includes means for generating a repeated tooth shaped waveform and means for comparing the input signal with the tooth shaped waveform to provide pulses whose width corresponds to the amplitude of the input signal.

6. Apparatus according to any preceding claim characterised by a low pass filter (5) connected to the output (3) of the pulse width modulator so as to provide an amplified version of the input signal.

7. Apparatus according to claim 6 characterised in that the said upper limit is a rate of change equal or less than the rate at which the input signal must rise, during a period equal to the delay time of the low pass filter, to produce pulses ranging from zero to 100% width.

8. Apparatus according to claim 6 or 7 characterised in that the frequency of the tooth shaped waveform is such that the input signal rising at the upper rate limit, between values which produce pulses of zero width and pulse of 100% width, crosses the tooth waveform at a number of points equal to or greater than three.

9. Apparatus comprising a resonant low pass filter characterised in that the filter (5) is arranged to receive signals via means (7) for imposing an upper limit on the rate of change of the signals, thereby preventing overshoot of the filter output (6).

10. Apparatus according to claim 9 characterised by means (7F) for adjusting the upper limit.

FILTER

AMP.

PULSE WIDTH ENCODER

BUFFER

7R

7Q

7E

7G

7K 7N

7L 7F

7C

7A

7H

7M 7J

7B

7D

7P

+15V

−15V

7

*Fig. I.*

0072181

FIG.2.